# EUROPEAN PATENT APPLICATION

(11) **EP 4 624 527 A1**
(43) Date of publication of application: **01.10.2025**
(21) Application number: 23894394.8
(22) Date of filing: 06.11.2023
(51) Int. Cl.: C08L 53/02, B32B 15/08, C08J 5/24, C08K 3/013, C08K 5/3415, C08L 9/00, C08L 101/00, H05K 1/03

(54) **RESIN COMPOSITION, PREPREG, RESIN FILM, LAMINATE, PRINTED WIRING BOARD AND SEMICONDUCTOR PACKAGE**

(30) Priority: 24.11.2022 JP 2022187132
(71) Applicant: Resonac Corporation, Tokyo 105-7325 (JP)
(72) Inventor: SATOU, Naoyosi, Tokyo 105-7325 (JP); TANIGAWA, Takao, Tokyo 105-7325 (JP); AKEBI, Ryuji, Tokyo 105-7325 (JP); HORIE, Akira, Tokyo 105-7325 (JP); SHIMIZU, Hiroshi, Tokyo 105-7325 (JP)
(74) Representative: Hoffmann Eitle
(86) International application number: PCT/JP2023/039789
(87) International publication number: WO 2024/111382

(57) **Abstract**

The present invention provides a resin composition and the like having excellent high-frequency characteristics, while exhibiting high adhesion to conductors and high heat resistance. The resin composition specifically contains a thermosetting resin (A), and a thermoplastic resin (B), in which the thermoplastic resin (B) contains a block copolymer (B1) including a block (b1) that contains a structural unit derived from an aromatic hydrocarbon compound, and a block (b2) that contains a structural unit derived from a conjugated diene compound, the component (B1) does not contain a diblock copolymer, or when the component (B1) contains a diblock copolymer, the content thereof is 50% by mass or less in the component (B1), and the weight-average molecular weight of the component (B1) is 130,000 or less.

## Description

### Technical Field

The present disclosure relates to a resin composition, a prepreg, a resin film, a laminate, a printed wiring board, and a semiconductor package.

### Background Art

In electronic devices such as a mobile communication device represented by a mobile phone, a network infrastructure device such as a base station device, a server, or a router, or a large computer, the speed and the capacity of a signal to be used are increasing year by year. Accordingly, for a substrate material of a printed wiring board to be mounted on the electronic devices, dielectric characteristics (hereinafter, referred to as "high-frequency characteristics") that can reduce a transmission loss of a high-frequency signal , that is, a low relative permittivity and a low dielectric dissipation factor are required.

In recent years, in addition to the electronic devices described above, in the field of intelligent transport systems (ITS) such as automobiles and traffic systems, and in the field of near distance communication in a room, practical use or practical plan of a new system handling high-frequency wireless signals has progressed. Therefore, in the future, it is expected that the necessity of a substrate material with excellent high-frequency characteristics is increased on the printed wiring board used in the fields.

The printed wiring board is required to have heat resistance and low thermal expansion that can withstand the use environment. For this reason, resins with excellent mechanical characteristics such as maleimide resin have been used for the printed wiring board. However, since many of these resins with excellent mechanical characteristics contain polar groups, improvement in high-frequency characteristics is required.

As a resin composition with improved high-frequency characteristics, a resin composition containing a resin or the like that contributes to a low dielectric dissipation factor such as a styrene-ethylene-butylene-styrene block copolymer (SEBS) is known (for example, see PTL 1).

### Citation List

### Patent Literature

PTL 1:JP-A-2022-059975

### Summary of Invention

### Technical Problem

However, as a result of intensive studies by the present inventors, it has been found that, depending on the type of styrene-ethylene-butylene-styrene block copolymer (SEBS), problems such as a decrease in adhesion to conductors and a decrease in heat resistance can occur.

In view of the above-described circumstances, an object of the present disclosure is to provide a resin composition with excellent high-frequency characteristics and capable of exhibiting high adhesion to conductors and high heat resistance, and to provide a prepreg, a resin film, a laminate, a printed wiring board, and a semiconductor package obtained by using the resin composition.

### Solution to Problem

As a result of intensive studies, the present inventors have found that the above object can be achieved with the resin composition of the present disclosure.

The present disclosure includes the following [1] to [14] embodiments.
[1] A resin composition, including:
   a thermosetting resin (A), and
   a thermoplastic resin (B), in which
   the thermoplastic resin (B) contains a block copolymer (B1) including a block (b1) that contains a structural unit derived from an aromatic hydrocarbon compound, and a block (b2) that contains a structural unit derived from a conjugated diene compound,
   the component (B1) does not contain a diblock copolymer, or when the component (B1) contains a diblock copolymer, the content of the diblock copolymer is 50% by mass or less in the component (B1), and
   the weight-average molecular weight of the component (B1) is 130,000 or less.
[2] The resin composition according to [1], in which
   the conjugated diene compound is one or more selected from the group consisting of butadiene and isoprene.
[3] The resin composition according to [1] or [2], in which
   in the component (B1), the block (b2) further contains a structural unit derived from an aromatic hydrocarbon compound, and in the block (b2), a content ratio of the structural unit derived from the conjugated diene compound to the structural unit derived from the aromatic hydrocarbon compound [structural unit derived from conjugated diene compound/structural unit derived from aromatic hydrocarbon compound] is 99/1 to 50/50.
[4] The resin composition according to [1] to [3], in which
   the thermosetting resin (A) contains one or more selected from the group consisting of an epoxy resin, a maleimide compound, a modified polyphenylene ether resin, a phenolic resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.
[5] The resin composition according to [4], in which
   the maleimide compound contains one or more selected from the group consisting of a maleimide compound having one or more N-substituted maleimide groups and a derivative of the maleimide compound.
[6] The resin composition according to [5], in which
   the maleimide compound contains one or more selected from the group consisting of an aromatic bismaleimide compound having two N-substituted maleimide groups bonded to an aromatic ring and an aromatic polymaleimide compound having three or more N-substituted maleimide groups bonded to an aromatic ring.
[7] The resin composition according to [6], in which
   the aromatic bismaleimide compound having two N-substituted maleimide groups bonded to an aromatic ring contains an indane ring-containing aromatic bismaleimide, and the aromatic polymaleimide compound having three or more N-substituted maleimide groups bonded to an aromatic ring contains a biphenyl aralkyl maleimide.
[8] The resin composition according to any one of [1] to [7], further including:
   an inorganic filler (C).
[9] The resin composition according to any one of [1] to [8], further including:
   (D) one or more selected from the group consisting of a conjugated diene polymer and a modified conjugated diene polymer.
[10] A prepreg including:
   the resin composition according to any one of [1] to [9] or a semi-cured product of the resin composition.
[11] A resin film including:
   the resin composition according to any one of [1] to [9] or a semi-cured product of the resin composition.
[12] A laminate including:
   a cured product of the resin composition according to any one of [1] to [9] or a cured product of the prepreg according to [10], and
   a metal foil.
[13] A printed wiring board including:
   a cured product of the resin composition according to any one of [1] to [9].
[14] A semiconductor package including:
   the printed wiring board according to [13], and
   a semiconductor element.

### Advantageous Effects of Invention

According to the present disclosure, it is possible to provide a resin composition with excellent high-frequency characteristics and capable of exhibiting high adhesion to conductors and high heat resistance, and to provide a prepreg, a resin film, a laminate, a printed wiring board, and a semiconductor package obtained by using the resin composition.

### Description of Embodiments

In the numerical range described in the present disclosure, the upper limit value or the lower limit value of the numerical range may be replaced with the values shown in the examples. The lower limit value and the upper limit value of the numerical range are arbitrarily combined with the lower limit value and the upper limit value of the other numerical ranges, respectively. In the description of the numerical range "AA to BB", the numerical values AA and BB at both ends are included in the numerical range as the lower limit value and the upper limit value, respectively.

In the present disclosure, for example, the description of "10 or more" means 10 and a numerical value exceeding 10, and the same applies to a case where the numerical value is different. In addition, for example, the description of "10 or less" means 10 and a numerical value less than 10, and the same applies to a case where the numerical value is different.

The components and materials exemplified in the present disclosure may be used alone or in combination of two or more kinds thereof, unless otherwise specified. In the present disclosure, the content of each component in the resin composition refers to the total amount of a plurality of substances present in the resin composition unless otherwise specified, when there are a plurality of substances corresponding to the respective components in the resin composition.

In the present disclosure, "resin component" refers to all components of the solid content constituting the resin composition, excluding inorganic compounds such as inorganic fillers as described below.

In the present disclosure, "solid content" refers to components other than solvents, and components in a liquid form at 25°C are also considered solid content.

The expression "containing XX" in the present disclosure may contain XX in a reacted state if XX can react, or may simply contain XX as it is, or may include both of these forms.

Any combination of the descriptions in the present disclosure is also included in the present disclosure and the present embodiment.

### [Resin Composition]

The resin composition of the present embodiment is as follows.

A resin composition including:
a thermosetting resin (A) [hereinafter, referred to as component (A)], and
a thermoplastic resin (B) [hereinafter, referred to as component (B)], in which
the thermoplastic resin (B) contains a block copolymer (B1) [hereinafter, referred to as component (B1)] including a block (b1) that contains a structural unit derived from an aromatic hydrocarbon compound, and a block (b2) that contains a structural unit derived from a conjugated diene compound,
the component (B1) does not contain a diblock copolymer, or when the component (B1) contains a diblock copolymer, the content of the diblock copolymer is 50% by mass or less in the component (B1), and
the weight-average molecular weight of the component (B1) is 130,000 or less.

The resin composition of the present embodiment can exhibit high adhesion to conductors and high heat resistance by limiting the content of diblock copolymer in the component (B1) and the weight-average molecular weight of the component (B1), while maintaining high-frequency characteristics at a high level by the component (B). It is presumed that by limiting the diblock copolymer, the reduction in the interaction between aromatic hydrocarbon compounds is suppressed, and as a result, the toughness of the resin composition or its cured product is improved, thereby exhibiting high adhesion and high heat resistance. It is also presumed that by limiting the weight-average molecular weight of the component (B1) to a predetermined value or less, the fluidity is reduced, and the embeddability of wiring is improved. Even if that presumption proves incorrect, it will not affect the scope of the present disclosure.

The components contained in the resin composition of the present embodiment will be described in detail below.

### ((A) Thermosetting Resin)

Examples of the component (A) include an epoxy resin, a maleimide compound, a modified polyphenylene ether resin, a phenolic resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. The modified polyphenylene ether resin is preferably a polyphenylene ether resin having an ethylenically unsaturated bond-containing group at the ends, and more preferably a polyphenylene ether resin having an ethylenically unsaturated bond-containing group at both ends. Here, examples of the "ethylenically unsaturated bond-containing group" include unsaturated aliphatic hydrocarbon groups such as a vinyl group, an allyl group, a 1-methylallyl group, an isopropenyl group, a 2-butenyl group, a 3-butenyl group, and a styryl group; and groups containing a heteroatom and an ethylenically unsaturated bond such as a maleimide group and a (meth)acryloyl group.

Among these, the component (A) preferably contains one or more selected from the group consisting of an epoxy resin, a maleimide compound, a phenolic resin, a polyimide resin, a cyanate resin, and an isocyanate resin, more preferably contains one or more selected from the group consisting of an epoxy resin and a maleimide compound, and even more preferably contains a maleimide compound from the viewpoint of low thermal expansion and the like.

The component (A) may be used alone, or in combination of two or more kinds thereof.

The epoxy resin is preferably an epoxy resin having two or more epoxy groups in one molecule. Here, the epoxy resin is classified into a glycidyl ether type epoxy resin, a glycidyl amine type epoxy resin, a glycidyl ester type epoxy resin, and the like. Among these, a glycidyl ether type epoxy resin is preferred.

Epoxy resins are also classified into various epoxy resins depending on the main backbone, and in each of the above types of epoxy resins, epoxy resins are further classified into bisphenol type epoxy resins such as bisphenol A type epoxy resin, bisphenol F type epoxy resin, and bisphenol S type epoxy resin; alicyclic epoxy resins such as dicyclopentadiene type epoxy resin; aliphatic chain epoxy resins; novolac type epoxy resins such as phenol novolac type epoxy resin, cresol novolac type epoxy resin, bisphenol A novolac type epoxy resin, bisphenol F novolac type epoxy resin, phenol aralkyl novolac type epoxy resin, and biphenyl aralkyl novolac type epoxy resin; stilbene type epoxy resins; naphthalene skeleton-containing epoxy resins such as naphthol novolac type epoxy resin and naphthol aralkyl type epoxy resin; biphenyl type epoxy resins; xylylene type epoxy resins; and dihydroanthracene type epoxy resins, or the like.

The maleimide compound preferably contains one or more selected from the group consisting of a maleimide compound having one or more N-substituted maleimide groups and a derivative of the maleimide compound. The maleimide compound having one or more N-substituted maleimide groups is preferably a maleimide compound having two or more N-substituted maleimide groups, more preferably a maleimide compound having 2 to 10 N-substituted maleimide groups, even more preferably a maleimide compound having 2 to 5 N-substituted maleimide groups, and particularly preferably a maleimide compound having two N-substituted maleimide groups.

In addition, as a maleimide compound having two or more N-substituted maleimide groups, a compound in which the nitrogen atoms of the maleimide groups are bonded to each other via organic groups is preferred.

Examples of the maleimide compound having one or more N-substituted maleimide groups are particularly not limited to, and are an aromatic maleimide compound having one N-substituted maleimide group preferably bonded to an aromatic ring, such as N-phenylmaleimide, N-(2-methylphenyl)maleimide, N-(4-methylphenyl)maleimide, N-(2,6-dimethylphenyl)maleimide, N-(2,6-diethylphenyl)maleimide, N-(2-methoxyphenyl)maleimide, and N-benzylmaleimide; an aromatic bismaleimide compound having two N-substituted maleimide groups preferably bonded to an aromatic ring, such as 4,4'-diphenylmethane bismaleimide, bis(4-maleimidophenyl)ether, bis(4-maleimidophenyl)sulfone, 3,3'-dimethyl-5,5'-diethyl-4,4'-diphenylmethane bismaleimide, 4-methyl-1,3-phenylene bismaleimide, m-phenylene bismaleimide, 2,2-bis[4-(4-maleimidophenoxy)phenyl]propane, an indane ring-containing aromatic bismaleimide; an aromatic polymaleimide compound having three or more N-substituted maleimide groups preferably bonded to an aromatic ring, such as polyphenylmethane maleimide and biphenyl aralkyl maleimide; and an aliphatic maleimide compound such as N-dodecylmaleimide, N-isopropylmaleimide, N-cyclohexylmaleimide, 1,6-bismaleimide-(2,2,4-trimethyl)hexane, and a pyrrolidone acid binder type long chain alkyl bismaleimide.

From the viewpoint of compatibility with other resins, adhesion to conductors, heat resistance, low thermal expansion, mechanical characteristics, and relative permittivity (Dk), the maleimide compound preferably contains one or more selected from the group consisting of an aromatic bismaleimide compound having two N-substituted maleimide groups bonded to an aromatic ring and an aromatic polymaleimide compound having three or more N-substituted maleimide groups bonded to an aromatic ring, and the aromatic bismaleimide compound having two N-substituted maleimide groups bonded to an aromatic ring preferably contains an indane ring-containing aromatic bismaleimide compound, and it is preferred that the aromatic polymaleimide compound having three or more N-substituted maleimide groups bonded to an aromatic ring contains a biphenyl aralkyl maleimide. In the present disclosure, the indane ring refers to a fused bicyclic structure of an aromatic 6-membered ring and a saturated aliphatic 5-membered ring. The indane ring-containing aromatic bismaleimide preferably has a divalent group represented by the following general formula (a1-1).

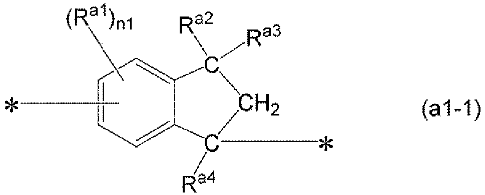

(In the formula, R^{a1} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, and n1 is an integer of 0 to 3. R^{a2} to R^{a4} are each independently an alkyl group having 1 to 10 carbon atoms. * denotes a binding site).

The indane ring-containing aromatic bismaleimide containing a divalent group represented by the general formula (a1-1) is preferably one represented by the following general formula (a1-2) from the viewpoints of a relative permittivity (Dk), adhesion to conductors, heat resistance, and ease of production.

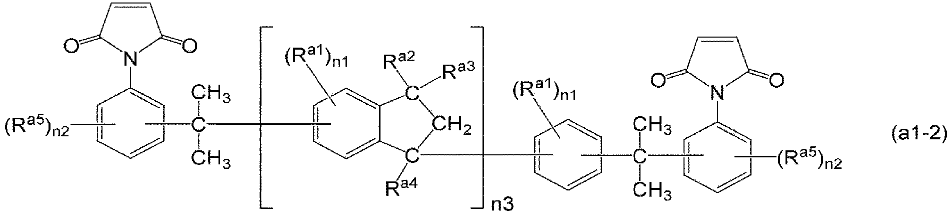

(In the formula, R^{a1} to R^{a4} and n1 are the same as in the general formula (a1-1). R^{a5} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group, n2 is each independently an integer of 0 to 4, and n3 is a number of 0.95 to 10.0.)

The indane ring-containing aromatic bismaleimide represented by the general formula (a1-2) is more preferably one represented by the following general formula (a1-3), or more preferably represented by the following general formula (a1-4), from the viewpoints of relative permittivity (Dk), adhesion to conductors, solvent solubility, and ease of production.

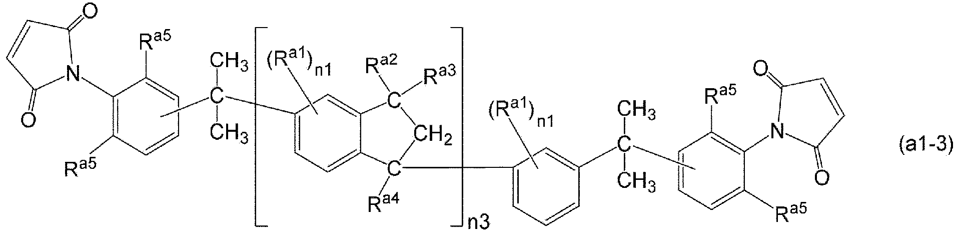

(In the formula, R^{a1} to R^{a5} and n1 and n3 are the same as in the general formula (a1-2).

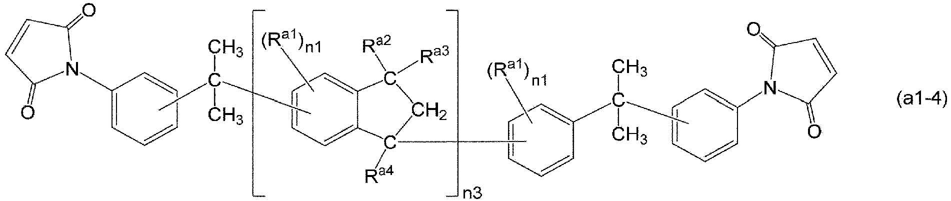

(In the formula, R^{a1} to R^{a4} and n1 and n3 are the same as in the general formula (a1-2).

A method for producing an indane ring-containing aromatic bismaleimide is not limited, and known methods can be referenced or applied.

Examples of the "derivative" of the maleimide compound include an addition reaction product of the maleimide compound having one or more (preferably two or more) N-substituted maleimide groups and an amine compound such as a monoamine compound and a diamine compound.

Examples of the monoamine compound include monoamine compounds having an acidic substituent, such as o-aminophenol, m-aminophenol, p-aminophenol, o-aminobenzoic acid, m-aminobenzoic acid, p-aminobenzoic acid, o-aminobenzenesulfonic acid, m-aminobenzenesulfonic acid, p-aminobenzenesulfonic acid, 3,5-dihydroxyaniline, and 3,5-dicarboxyaniline.

Examples of the diamine compound include an aromatic diamine compound in which an amino group is bonded to an aromatic hydrocarbon group, such as 4,4'-diaminodiphenylmethane, 4,4'-diaminodiphenylethane, 4,4'-diaminodiphenylpropane, 2,2'-bis(4,4'-diaminodiphenyl)propane, 3,3'-dimethyl-4,4'-diaminodiphenylmethane, 3,3'-diethyl-4,4'-diaminodiphenylmethane, 3,3'-dimethyl-4,4'-diaminodiphenylethane, 3,3'-diethyl-4,4'-diaminodiphenylethane, 4,4'-diaminodiphenyl ether, 4,4'-diaminodiphenyl thioether, 3,3'-dihydroxy-4,4'-diaminodiphenylmethane, 2,2',6,6'-tetramethyl-4,4'-diaminodiphenylmethane, 3,3'-dichloro-4,4'-diaminodiphenylmethane, 3,3'-dibromo-4,4'-diaminodiphenylmethane, 2,2',6,6'-tetrachloro-4,4'-diaminodiphenylmethane, 2,2',6,6'-tetrabromo-4,4'-diaminodiphenylmethane; a siloxane diamine.

### (Content of Component (A))

The content of the thermosetting resin (A) in the resin composition of the present embodiment is not particularly limited, and from the viewpoint of heat resistance and moldability, is preferably 1 to 60 parts by mass, more preferably 3 to 50 parts by mass, even more preferably 5 to 40 parts by mass, particularly preferably 5 to 30 parts by mass, and most preferably 5 to 25 parts by mass, with respect to 100 parts by mass of the total solid content in the resin composition, from the viewpoint of heat resistance and moldability.

### ((B) Thermoplastic Resin

From the viewpoint of high-frequency characteristics, the resin composition of the present embodiment contains a thermoplastic resin as the component (B). From the viewpoint of high-frequency characteristics, adhesion to conductors and heat resistance, the component (B) contains the following component (B1).

The component (B1) contains a block copolymer including a block (b1) that contains a structural unit derived from an aromatic hydrocarbon compound, and a block (b2) that contains a structural unit derived from a conjugated diene compound,
the component (B1) does not contain a diblock copolymer, or when the component (B1) contains a diblock copolymer, the content of the diblock copolymer is 50% by mass or less in the component (B 1), and
the weight-average molecular weight of the component (B1) is 130,000 or less.

In the structural unit derived from a conjugated diene compound, from the viewpoint of high-frequency characteristics, examples of the conjugated diene compound include 1,3-butadiene (hereinafter, simply referred to as butadiene), isoprene, 1,3-pentadiene, 2,3-dimethyl-1,3-butadiene, 2-phenyl-1,3-butadiene, and 1,3-hexadiene. The conjugated diene compound is preferably one or more selected from the group consisting of butadiene and isoprene, more preferably contains butadiene, and even more preferably is butadiene.

The structural unit derived from the conjugated diene compound is not particularly limited, and examples thereof include a 1,2-bond unit of butadiene, a 1,4-bond unit of butadiene, a 3,4-bond unit of isoprene, a 1,4-bond unit of isoprene, and bond units obtained by hydrogenating these bond units. Here, examples of the bond units in which these bond units are hydrogenated include, specifically, as shown in the structural formula below, "butylene unit" that is a bond unit in which the 1,2-bond unit of butadiene is hydrogenated, and "ethylene unit" that is a bond unit in which the 1,4-bond unit of butadiene is hydrogenated (in general, this is so named by referring to the structural units enclosed in parentheses in the structural formula below. The parentheses are for explanatory purposes and are not intended to separate the structural units), "ethylene-butylene unit" having both the butylene unit and the ethylene unit, "isopentene unit" in which the 3,4-bond unit of isoprene is hydrogenated ("3-methyl-1-butene unit"), "ethylene-propylene unit" that is a bond unit in which the 1,4-bond unit of isoprene is hydrogenated (in general, this is so named by referring to the structural units enclosed in parentheses in the structural formula below. The parentheses are for explanatory purposes and are not intended to separate the structural units) (see structural formula below). 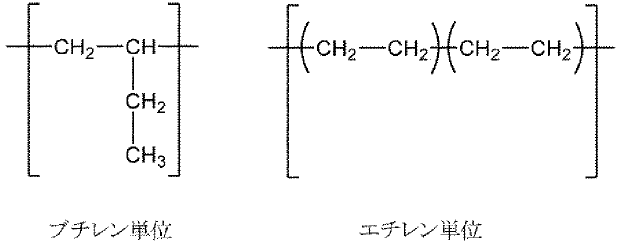 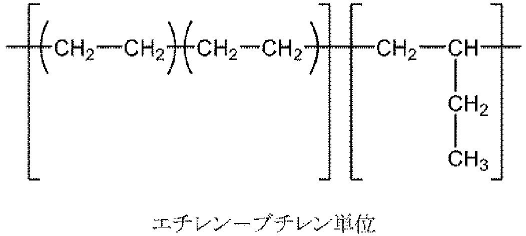 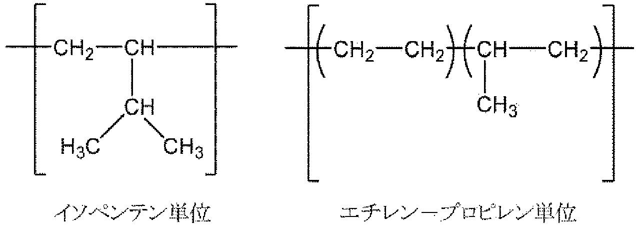
Butylene Unit
Ethylene Unit
Ethylene-butylene Unit
Isopentene Unit
Ethylene-propylene unit

The structural unit derived from the conjugated diene compound is preferably a butylene unit, an ethylene unit, or an ethylene-butylene unit, more preferably an ethylene-butylene unit, from the viewpoint of high-frequency characteristics.

Examples of the aromatic vinyl compound in the structural unit derived from the aromatic hydrocarbon compound include styrene, α-methylstyrene, 2,4-dimethylstyrene, 1-methylvinyl naphthalene, 4-methoxystyrene, monochlorostyrene, and divinylbenzene. Among these, styrene is preferred.

As described above, the component (B1) is a block copolymer having a block (b1) containing a structural unit derived from an aromatic hydrocarbon compound and a block (b2) containing a structural unit derived from a conjugated diene compound.

The content of the structural unit derived from the aromatic hydrocarbon compound in the block (b1) is preferably 80% by mass or more, more preferably 90% by mass or more, even more preferably 95% by mass or more, particularly preferably 98% by mass or more, and may be 100% by mass.

The content of the structural unit derived from the conjugated diene compound in the block (b2) is preferably 80% by mass or more, more preferably 90% by mass or more, even more preferably 95% by mass or more, particularly preferably 98% by mass or more, and may be 100% by mass.

The block (b2) may further contain a structural unit derived from an aromatic hydrocarbon compound, and in that case, in the block (b2), the content ratio [structural unit (1)/structural unit (2)] of a structural unit ("structural unit (1)") derived from a conjugated diene compound and a structural unit ("structural unit (2)") derived from an aromatic hydrocarbon compound is not limited, and from the viewpoint of high-frequency characteristics, adhesion to conductors, and heat resistance, the mass ratio is preferably 99/1 to 50/50, more preferably 95/5 to 60/40, and even more preferably 90/10 to 65/35.

The total content of "the block (b1) containing a structural unit derived from an aromatic hydrocarbon compound and the block (b2) containing a structural unit derived from a conjugated diene compound" in the component (B1) is not particularly limited, and may be 20% by mass or more, 40% by mass or more, 50% by mass or more, 80% by mass or more, 90% by mass or more, 95% by mass or more, 98% by mass or more, or 100% by mass, with respect to the entire component (B1).

As described above, the component (B1) does not contain a diblock copolymer, or when a diblock copolymer is contained, the content thereof is 50% by mass or less in the component (B1). When this condition is satisfied, adhesion to conductors is enhanced, and the heat resistance is also improved.

It is preferable that the component (B1) contains no diblock copolymer, or when a diblock copolymer is contained, the content thereof is 30% by mass or less in the component (B1), and it is more preferable that no diblock copolymer is contained, or when a diblock copolymer is contained, the content thereof is 10% by mass or less in the component (B1), and it is even more preferable that no diblock copolymer is contained, or when a diblock copolymer is contained, the content thereof is 3% by mass or less in the component (B1), and particularly preferably no diblock copolymer is contained.

In the component (B1), the hydrogenation ratio is preferably 70 mol% or more, more preferably 80 mol% or more, even more preferably 90 mol% or more, particularly preferably 95 mol% or more. The upper limit of the hydrogenation ratio is not particularly limited, and may be 100 mol% or less or 99 mol% or less. That is, the hydrogenation ratio may be 70 to 100 mol%.

The component (B1) may be modified with an acid anhydride such as maleic anhydride. The acid value of the acid-denatured (B1) component is not particularly limited, and is preferably 2 to 20 mgCH₃ONa/g, more preferably 5 to 15 mgCH₃ONa/g, and even more preferably 7 to 13 mgCH₃ONa/g.

The weight-average molecular weight (Mw) of the component (B1) is 130,000 or less as described above. When this condition is satisfied, the lowest melt viscosity tends to decrease, and the embeddability of the wiring tends to increase.

From the viewpoint of the above effect, the weight-average molecular weight (Mw) of the component (B1) is preferably 12,000 to 120,000, more preferably 30,000 to 115,000, may be 50,000 to 110,000, may be 50,000 to 90,000, may be 55,000 to 130,000, may be 55,000 to 115,000, may be 55,000 to 110,000, may be 55,000 to 90,000, may be 60,000 to 85,000, may be 12,000 to 100,000, may be 12,000 to 90,000, or 12,000 to 80,000.

In the present disclosure, the weight-average molecular weight (Mw) is a value measured in polystyrene equivalent by gel permeation chromatography (GPC), and is a value measured by the method described in the examples in detail.

### (Content of Component (B) and Content of Component (B1))

The content of the component (B) in the resin composition of the present embodiment is not particularly limited, and is preferably 1 to 55 parts by mass, more preferably 5 to 50 parts by mass, even more preferably 5 to 40 parts by mass, and particularly preferably 5 to 35 parts by mass, with respect to 100 parts by mass of the total solid content in the resin composition. When the content of the component (B) is equal to or more than the lower limit value, the high-frequency characteristics tend to be more excellent, and when the content of the component is equal to or less than the upper limit value, good heat resistance, moldability, processability, and flame retardancy tend to be obtained.

The content of the component (B1) in the component (B) is preferably 80 to 100% by mass, more preferably 90 to 100% by mass, even more preferably 95 to 100% by mass, and particularly preferably 100% by mass, from the viewpoint of high-frequency characteristics, adhesive strength with conductors and heat resistance.

### (Inorganic Filler (C))

By containing an inorganic filler (C) [hereinafter, referred to as component (C)] in the resin composition of the present embodiment, low coefficient of thermal expansion, heat resistance, and flame retardancy tend to be improved.

Specific examples of the component (C) are not particularly limited to, and include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay (baked clay, and the like), a molybdic acid compound such as zinc molybdate, talc, aluminum borate, and silicon carbide. The component (C) may be used alone or in combination of two or more kinds thereof. Among these, silica, alumina, mica, and talc are preferred, silica and alumina are more preferred, and silica is more preferred from the viewpoint of coefficient of thermal expansion, heat resistance and flame retardance. Examples of silica include crushed silica, fumed silica, and fused silica (fused spherical silica).

The shape and particle size of the component (C) are not particularly limited, and the particle diameter is preferably 0.01 to 20 µm, more preferably 0.1 to 10 µm, even more preferably 0.2 to 1 µm, particularly preferably 0.3 to 0.8 µm. Here, the particle diameter refers to an average particle diameter, and refers to a particle diameter at a point corresponding to a volume of 50% when a cumulative frequency distribution curve according to the particle diameter is obtained by setting the total volume of the particles to 100%. The particle diameter of the component (C) can be measured by a particle size distribution measuring device or the like using a laser diffraction scattering method.

### (Content of Component (C))

When the resin composition of the present embodiment contains the component (C), the content of the component (C) is not particularly limited, and is preferably 5 to 70 parts by mass, more preferably 15 to 65 parts by mass, even more preferably 20 to 60 parts by mass, and particularly preferably 30 to 55 parts by mass, with respect to 100 parts by mass of the total solid content in the resin composition, from the viewpoint of coefficient of thermal expansion, heat resistance, and flame retardancy.

In addition, when the component (C) is used, for the purpose of improving the dispersibility of the component (C) and the adhesion between the component (C) and organic components in the resin composition, a coupling agent may be used in combination as needed. The coupling agent is not particularly limited, and for example, a silane coupling agent or titanate coupling agent can be selected as appropriate. These coupling agents may be used alone or in combination of two or more kinds thereof. In addition, the amount of the coupling agent used is not particularly limited.

When using a coupling agent, the so-called integral blend processing method, in which the coupling agent is added after blending the component (C) in the resin composition, is acceptable, but the method using an inorganic filler that has been surface treated with a coupling agent dry or wet beforehand is preferred. By adopting this method, the characteristics of the component (C) can be more effectively exhibited.

When the component (C) is used in the present embodiment, for the purpose of improving the dispersibility of the component (C) in the resin composition, if necessary, the (C) component can be used as a slurry pre-dispersed in an organic solvent. Examples of the organic solvent include the same organic solvents as described later.

((D) one or more Selected from Group Consisting of Conjugated Diene Polymer and Modified Conjugated Diene Polymer)

From the viewpoint of the relative permittivity (Dk), the resin composition of the present embodiment may further contain (D) one or more selected from the group consisting of a conjugated diene polymer and a modified conjugated diene polymer [hereinafter, referred to as component (D)]. The component (D) is not contained in the component (A) and the component (B).

The component (D) may be used alone or in combination of two or more kinds thereof.

### (Conjugated Diene Polymer)

In the present disclosure, "conjugated diene polymer" refers to a polymer of a conjugated diene compound.

When the resin composition of the present embodiment contains a conjugated diene polymer, an excellent relative permittivity (Dk) tends to be easily obtained.

Examples of the conjugated diene compound which is a monomer component of the conjugated diene polymer include 1,3-butadiene, isoprene, 1,3-pentadiene, 2,3-dimethyl-1,3-butadiene, 2-phenyl-1,3-butadiene, and 1,3-hexadiene.

The conjugated diene polymer may be a polymer of one conjugated diene compound or a copolymer of two or more conjugated diene compounds.

The conjugated diene polymer is preferably a conjugated diene polymer having a vinyl group in a side chain from the viewpoint of compatibility with other resins and relative permittivity (Dk).

The number of side-chain vinyl groups in one molecule of the conjugated diene polymer is not particularly limited, and is preferably 2 or more, more preferably 5 or more, and even more preferably 10 or more from the viewpoint of compatibility with other resins and relative permittivity (Dk).

The upper limit of the number of side-chain vinyl groups in one molecule of the conjugated diene polymer is not particularly limited, and may be, for example, 100 or less, 80 or less, or 60 or less.

Examples of the conjugated diene polymer include polybutadiene having a vinyl group and polyisoprene having a vinyl group. Among these, polybutadiene having a vinyl group is preferred, and polybutadiene having a 1,2-vinyl group derived from 1,3-butadiene is more preferred from the viewpoint of relative permittivity (Dk) and heat resistance. In addition, the polybutadiene having a 1,2-vinyl group derived from 1,3-butadiene is preferably a polybutadiene homopolymer having a 1,2-vinyl group derived from 1,3-butadiene.

The 1,2-vinyl group derived from 1,3-butadiene contained in the conjugated diene polymer is a vinyl group contained in the structural unit represented by the following formula (D-1).

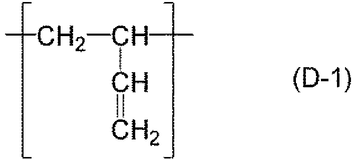

When the conjugated diene polymer is polybutadiene having a 1,2-vinyl group, the content of the structural unit having a 1,2-vinyl group (hereinafter, referred to as "vinyl group content") based on the total structural units derived from butadiene constituting the polybutadiene is not particularly limited, and is preferably 50 mol% or more, more preferably 70 mol% or more, and still more preferably 85 mol% or more, from the viewpoint of compatibility with other resins, relative permittivity (Dk), and heat resistance. The upper limit of the vinyl group content is not particularly limited, and may be 100 mol% or less, may be 95 mol% or less, or may be 90 mol% or less. The structural unit having a 1,2-vinyl group is preferably a structural unit represented by the above formula (D-1).

From the same viewpoint, the polybutadiene having a 1,2-vinyl group is preferably a 1,2-polybutadiene homopolymer.

The number-average molecular weight (Mn) of the conjugated diene polymer is not particularly limited, and is preferably 400 to 3,000, more preferably 600 to 2,000, and still more preferably 800 to 1,500, from the viewpoint of compatibility with other resins, relative permittivity (Dk), and heat resistance.

### (Modified Conjugated Diene Polymer)

A modified conjugated diene polymer is a polymer obtained by modifying a conjugated diene polymer.

When the resin composition of the present embodiment contains a modified conjugated diene polymer, excellent relative permittivity (Dk) tends to be easily obtained while having good heat resistance and low thermal expansion.

As the modified conjugated diene polymer, a modified conjugated diene polymer obtained by modifying a conjugated diene polymer having a vinyl group in a side chain with a maleimide compound having two or more N-substituted maleimide groups is preferred from the viewpoint of compatibility with other resins, relative permittivity (Dk), and adhesion to conductors.

As the conjugated diene polymer having a vinyl group in the side chain, for example, the conjugated diene polymer described in the description of the conjugated diene polymer may be used, and preferred embodiments thereof are also the same.

The conjugated diene polymer having a vinyl group in a side chain may be used alone or may be used in combination of two or more kinds thereof.

As the maleimide compound having two or more N-substituted maleimide group, for example, a maleimide compound having two or more N-substituted maleimide groups in the description of the maleimide compound in the component (A) can be used. Examples of the maleimide compound having two or more N-substituted maleimide groups include 3,3'-dimethyl-5,5'-diethyl-4,4 ' -diphenylmethane bismaleimide and 4-methyl-1,3-phenylene bismaleimide. Among these, from the viewpoints of solubility in an organic solvent and suppression of gelation during the reaction, and compatibility with other resins to be obtained, dielectric characteristics, low thermal expansion, and heat resistance, as a maleimide compound having two or more N-substituted maleimide groups, 3,3'-dimethyl-5,5'-diethyl-4,4'-diphenylmethane bismaleimide is preferred.

The maleimide compound having two or more N-substituted maleimide groups may be used alone or may be used in combination of two or more kinds thereof.

The modified conjugated diene polymer preferably has, in a side chain, a substituent formed by a reaction between a side-chain vinyl group of a conjugated diene polymer having a vinyl group in a side chain and an N-substituted maleimide group of a maleimide compound having two or more N-substituted maleimide groups [hereinafter, referred to as a "maleimide compound-derived substituent"].

The maleimide compound-derived substituent is preferably a group containing a structure represented by the following general formula (D-2) or (D-3) as a structure derived from a maleimide compound having two or more N-substituted maleimide groups, from the viewpoint of compatibility with other resins, relative permittivity (Dk), low thermal expansion, and heat resistance.

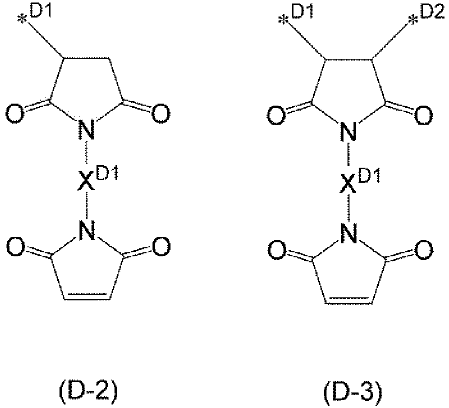

(In the formula, X^{D1} is a divalent group obtained by removing two N-substituted maleimide groups from a maleimide compound having two or more N-substituted maleimide groups, *^{D1} is a site bonded to a carbon atom derived from a side-chain vinyl group of a conjugated diene polymer having a vinyl group in a side chain, and *^{D2} is a site bonded to another atom.)

The modified conjugated diene polymer preferably has a maleimide compound-derived substituent and a vinyl group in a side chain.

The vinyl group contained in the modified conjugated diene polymer is preferably a 1,2-vinyl group derived from 1,3-butadiene.

The number-average molecular weight (Mn) of the modified conjugated diene polymer is not particularly limited, and is preferably 700 to 6,000, more preferably 800 to 5,000, and still more preferably 1,000 to 2,500, from the viewpoint of compatibility with other resins, relative permittivity (Dk), low thermal expansion, and heat resistance.

The modified conjugated diene polymer can be produced by reacting a conjugated diene polymer having a vinyl group in a side chain with a maleimide compound having two or more N-substituted maleimide groups. The method for reacting the conjugated diene polymer having a vinyl group in a side chain with the maleimide compound having two or more N-substituted maleimide groups is not particularly limited. For example, a conjugated diene polymer having a vinyl group in a side chain, a maleimide compound having two or more N-substituted maleimide groups, a reaction catalyst, and an organic solvent are charged into a reaction vessel, and the mixture is reacted while, as necessary, heating, keeping warm, stirring, and the like to obtain a modified conjugated diene polymer.

The ratio (Mₘ/Mᵥ) of the number of moles (Mₘ) of the N-substituted maleimide group in the maleimide compound having two or more N-substituted maleimide groups to the number of moles (Mᵥ) of the side-chain vinyl group in the conjugated diene polymer having a vinyl group in a side chain during the reaction is not particularly limited, and is preferably 0.001 to 0.5, more preferably 0.005 to 0.1, and even more preferably 0.008 to 0.05 from the viewpoint of compatibility with other resins of the resulting modified conjugated diene polymer and suppression of gelation of the product during the reaction.

### (Content of Component (D))

When the resin composition of the present embodiment contains the component (D), the content of the component (D) is not particularly limited, and is preferably 1 to 50 parts by mass, more preferably 3 to 30 parts by mass, and even more preferably 5 to 25 parts by mass, with respect to 100 parts by mass of the total solid content of the resin composition, from the viewpoint of high-frequency characteristics and compatibility. When the content of the component (D) is the lower limit value or more, the high-frequency characteristics tend to be good, and the compatibility tends to be good. When the content of the component (D) is the upper limit value or less, heat resistance, moldability, and processability tend to be good.

### (Curing Accelerator (E))

Examples of the curing accelerator (E) [hereinafter, referred to as component (E)] include amine-based curing accelerators, imidazole-based curing accelerators, phosphorus-based curing accelerators, organometallic salts, acidic catalysts, and organic peroxides. **In** the present disclosure, imidazole-based curing accelerators are not classified as amine-based curing accelerators. These curing accelerators may be used alone or in combination of two or more kinds thereof. The curing accelerator preferably includes one or more selected from the group consisting of imidazole-based curing accelerators and organic peroxides.

Examples of the imidazole-based curing accelerator include an imidazole compound such as methylimidazole, phenylimidazole, and 2-undecylimidazole; and isocyanate mask imidazole such as addition reaction products of hexamethylene diisocyanate resin and 2-ethyl-4-methylimidazole.

Examples of the organic peroxide include dicumyl peroxide, 2,5-dimethyl-2,5-bis(t-butylperoxy)hexyne-3, 2,5-dimethyl-2,5-bis(t-butylperoxy)hexane, t-butylperoxyisopropyl monocarbonate, α,α'-bis(t (-butylperoxy)diisopropylbenzene.

### (Content of Curing Accelerator (E))

When the resin composition of the present embodiment contains the component (E), the content of the component (E) is not particularly limited, and is preferably 0.01 to 3.5 parts by mass, more preferably 0.05 to 3.0 parts by mass, even more preferably 0.1 to 3.0 parts by mass, and particularly preferably 0.3 to 3.0 parts by mass, with respect to 100 parts by mass of the total solid content in the resin composition. When the content of the curing accelerator (E) is within the above range, better heat resistance, storage stability, and moldability tend to be obtained.

### (Other Components)

It is preferred that the resin composition of the present embodiment further contains, as other components, one or more selected from the group consisting of a flame retardant, a flame-retardant auxiliary, an antioxidant, an adhesion improver, a heat stabilizer, an antistatic agent, a UV absorber, a pigment, a colorant, and a lubricant. In addition, components other than the above may be contained.

When the resin composition of the present embodiment contains these other components (a flame retardant, a flame retardant auxiliary, an antioxidant, an adhesion improver, a heat stabilizer, an antistatic agent, a UV absorber, a pigment, a colorant, a lubricant, and components other than these), the content of each of the components is not particularly limited, and may be, for example, 0.01 parts by mass or more, 10 parts by mass or less, 5 parts by mass or less, 1 parts by mass or less, or may not be contained with respect to 100 parts by mass of the total of the resin components in the resin composition.

### (Organic Solvent)

The resin composition of the present embodiment may be a so-called "varnish" containing an organic solvent from the viewpoint of easier handling and easier production of a prepreg or a resin film as described below.

Examples of the organic solvent are not particularly limited to, and include alcohol-based solvents such as ethanol, propanol, butanol, methyl cellosolve, butyl cellosolve, and propylene glycol monomethyl ether; ketone-based solvents such as acetone, methyl ethyl ketone, methyl isobutyl ketone, and cyclohexanone; ether-based solvents such as tetrahydrofuran; aromatic solvents such as toluene, xylene, and mesitylene; nitrogen atom-containing solvents such as dimethylformamide, dimethylacetamide, and N-methylpyrrolidone; sulfur atom-containing solvents such as dimethyl sulfoxide; and ester-based solvents such as γ-butyrolactone. From the viewpoint of solubility, a ketone-based solvent is preferred, and a methyl ethyl ketone is more preferred. These organic solvents may be used alone or in combination of two or more kinds thereof.

When the resin composition of the present embodiment is used as a varnish, the solid content concentration is set to preferably 30 to 90% by mass, more preferably 40 to 80% by mass, and still more preferably 45 to 60% by mass. When the solid content concentration of the resin composition is within the above range, the resin compositions are easy to handle, impregnation into the base material and the appearance of the prepreg produced are excellent, and the coating properties when made into resin film are also excellent.

The resin composition of the present embodiment can be produced by mixing the component (A), the component (B), and the components that can be used as necessary by a known method. At this time, the respective components may be dissolved or dispersed in the organic solvent while stirring. Conditions such as mixing order, temperature, and time are not particularly limited, and can be arbitrarily set.

### [Prepreg]

The prepreg of the present embodiment is a prepreg containing the resin composition of the present embodiment or a semi-cured product of the resin composition.

The prepreg of the present embodiment contains, for example, the resin composition of the present embodiment or a semi-cured product of the resin composition and a sheet-shaped fiber base material. The prepreg is formed by using the resin composition of the present embodiment or the resin film described below, and a sheet-shaped fiber base material. For example, the prepreg can be obtained by impregnating the resin composition of the present embodiment or the resin film to be described later into a sheet-shaped fiber base material, then heated and dried and semi-hardened (B-staging) as necessary. More specifically, for example, the prepreg of the present embodiment can be produced by semi-curing (B-stage) by heating and drying usually at 80 to 200°C for 1 to 30 minutes in a drying furnace. Here, in the present disclosure, B-staging is to bring into a B-stage state as defined in JIS K6900 (1994).

The amount of the resin composition to be used can be appropriately determined for the purpose of setting the solid content concentration derived from the resin composition in the prepreg after drying to 30 to 90% by mass. When the solid content concentration is set to be in the above-described range, better moldability tends to be obtained when a laminate is formed.

As the sheet-shaped fiber base material of the prepreg, known materials used for various laminates for electrical insulating materials can be used. Examples of the material of the sheet-shaped fiber base material include inorganic fibers such as E glass, D glass, S glass, and Q glass; organic fibers such as polyimide, polyester, and tetrafluoroethylene; and mixtures thereof. These sheet-shaped fiber base materials have forms such as a woven fabric, a nonwoven fabric, a roving, a chopped strand mat, or a surfacing mat.

The thickness of the sheet-shaped fiber base material is not particularly limited, and may be 1 to 100 µm, 3 to 70 µm, 5 to 55 µm, 15 to 55 µm, or 25 to 55 µm.

### [Resin Film]

The resin film of the present embodiment is a resin film containing the resin composition of the present embodiment or a semi-cured product of the resin composition.

The resin film of the present embodiment can be produced, for example, by applying a resin composition containing an organic solvent, that is, a varnish, to a support, heating and drying the varnish, and semi-curing (B-staging) the varnish as necessary. The thickness of the resin film is not limited, and is preferably 1 to 100 µm, more preferably 3 to 70 µm, and even more preferably 5 to 35 µm.

Examples of the support include a plastic film, a metal foil, and a release paper.

The drying temperature and the drying time may be appropriately determined according to the amount of the organic solvent to be used, the boiling point of the organic solvent to be used, and the like, but the resin film can be suitably formed by drying at 50 to 200°C for about 1 to 10 minutes.

### [Laminate]

The laminate of the present embodiment is a laminate including a cured product of the resin composition of the present embodiment, a cured product of a prepreg, and a metal foil.

The laminate of the present embodiment can be produced, for example, by disposing metal foil on one or both sides of a single prepreg of the present embodiment, or by disposing metal foil on one or both sides of a laminate obtained by stacking two or more prepregs of the present embodiment, followed by heat and pressure molding. In the laminate obtained by the production method, the prepreg of the present embodiment is C-staged. In the present disclosure, C-staging is to bring into a C-stage state as defined in JIS K6900 (1994). The laminate having a metal foil may also be referred to as a metal-clad laminate.

The metal of the metal foil is not particularly limited, and from the viewpoint of conductivity, the metal may be copper, gold, silver, nickel, platinum, molybdenum, ruthenium, aluminum, tungsten, iron, titanium, chromium, or an alloy containing one or more of these metallic elements, and is preferably copper or aluminum, more preferably copper.

The method for implementing heat and pressure molding is not particularly limited, and can be implemented, at a temperature of 100 to 300°C, a pressure of 0.2-10 MPa for 0.1 to 5 hours, for example. **In** addition, a method for maintaining a vacuum state for 0.5 to 5 hours using a vacuum press can be adopted for the heat and pressure molding.

### [Printed Wiring Board]

The printed wiring board of the present embodiment has a cured product of the resin composition of the present embodiment. **In** addition, the printed wiring board of the present embodiment can also be referred to as a printed wiring board having one or more selected from the group consisting of the cured product of the thermosetting resin composition of the present embodiment, the cured product of the prepreg of the present embodiment, and the laminate of the present embodiment.

The printed wiring board of the present embodiment can be produced by using one or more selected from the group consisting of the prepreg of the present embodiment, the resin film of the present embodiment, and the laminate of the present embodiment, and performing circuit formation processing by drilling, metal plating, etching of a metal foil, or the like by a known method. In addition, a multilayer printed wiring board can also be produced by further performing a multilayer adhesion process as necessary. In the printed wiring board of the present embodiment, the prepreg of the present embodiment and the resin film of the present embodiment is C-staged.

### [Semiconductor Package]

The semiconductor package of the present embodiment is a semiconductor package having the printed wiring board of the present embodiment and a semiconductor element. The semiconductor package of the present embodiment can be produced by mounting semiconductor elements such as semiconductor chips and memory at predetermined position on the printed wiring board of the present embodiment.

The resin composition, the prepreg, the resin film, the laminate, the printed wiring board, and the semiconductor package of the present embodiment can be suitably used in an electronic device that handles a high-frequency signal of 10 GHz or more. **In** particular, the printed wiring board is useful as a printed wiring board for millimeter-wave radar.

Although preferred embodiments have been described above, these are examples for describing the present disclosure, and the scope of the present disclosure is not limited to these embodiments. The present disclosure may include various aspects different from the embodiment without departing from the gist of the present disclosure.

### Examples

Hereinafter, the present embodiment will be specifically described with reference to examples. However, the present embodiment is not limited to the following examples.

In each example, the weight-average molecular weight (Mw) was measured by the following method.

### (Method for Measuring weight-average molecular weight (Mw))

By gel permeation chromatography (GPC), the weight-average molecular weight was converted from a calibration curve using standard polystyrene. The calibration curve was approximated by a cubic equation using standard polystyrene: TSK standard POLYSTYRENE (Type; A-2500, A-5000, F-1, F-2, F-4, F-10, F-20, F-40) [manufactured by Tosoh Corporation, trade name]. The measurement conditions of GPC are shown below.

Device:
Pump: L-6200 type (manufactured by Hitachi High-Tech Corporation)
Detector: L-3300 type RI (manufactured by Hitachi High-Tech Corporation)
Column oven: L-655A-52 (manufactured by Hitachi High-Tech Corporation)
Column: Guard column; TSK Guardcolumn HHR-L + column; TSKgel G4000HHR + TSKgel G2000HHR (all manufactured by Tosoh Corporation, trade name)
Column size: 6.0 × 40 mm (guard column), 7.8 × 300 mm (column)
Eluent: tetrahydrofuran
Sample concentration: 30 mg / 5 mL
Injection amount: 20 µL
Flow rate: 1.00 mL / min
Measurement temperature: 40°C.

### Production Example 1 [Production of Modified Conjugated Diene Polymer (for Component (D)]

Into a container having a volume of 2 L capable of being heated and cooled and equipped with a thermometer, a reflux cooling pipe, and a stirring device, 100 parts by mass of 1,2-polybutadiene homopolymer (number-average molecular weight (Mn) = 1,200, vinyl group content = 85% or more), 4.4 parts by mass of 3,3'-dimethyl-5,5'-diethyl-4,4'-diphenylmethanebismaleimide, 0.1 parts by mass of α,α'-bis(t-butylperoxy)diisopropylbenzene, and toluene as an organic solvent were charged. Next, the mixture was stirred at 90°C to 100°C for 5 hours in a nitrogen atmosphere, thereby obtaining a solution of a modified conjugated diene polymer having a solid content concentration of 35% by mass.

### [Examples 1 to 3 and Comparative Examples 1 to 4]

Aresin composition (varnish) with a solid content concentration of approximately 50% by mass was prepared by mixing and stirring each of the components listed in Table 1, together with toluene, at room temperature according to the amounts in Table 1.

The varnish obtained above was coated onto 43 µm thick glass woven fabric (NE Glass Cloth #1078, manufactured by Nittobo Co., Ltd.), and then heated and dried at 100°C for 5 minutes to produce a prepreg with a resin composition-derived solid content of approximately 75% by mass. A double-sided copper-clad laminate (thickness: 1 mm) was produced by disposing 18 µm thick low-profile copper foil (BF-ANP18, manufactured by Circuit Foil) on the top and bottom of a laminate superimposed six prepregs so that the M side (matte side) comes into contact with the prepregs, followed by heat and pressure molding at a temperature of 190°C and a pressure of 2.0 MPa for 80 minutes.

The resin compositions or double-sided copper-clad laminates obtained in each example were evaluated according to the following methods. The results are shown in Table 1.

### [Evaluation of Double-Sided Copper-Clad Laminate]

### (1. Measurement of Dielectric Dissipation Factor (Df))

The copper foils on both sides of the double-sided copper-clad laminate obtained in each example were removed by etching, cut into a length of 60 mm and a width of 2 mm as test pieces, and the dielectric dissipation factor (Df) was measured by a cavity resonator perturbation method. A vector type network analyzer "N5222B" manufactured by Agilent Technologies, Inc. was used as a measurement instrument, a cavity resonator "CP129" (10 GHz band resonator) manufactured by Kanto Electronics Application & Development Inc. was used as a cavity resonator, and a measurement program "CPMA-V2" was used as a measurement program. The measurement was performed under conditions of a frequency of 10 GHz and a measurement temperature of 25°C.

### (2. Evaluation of Adhesion to Conductors)

The copper foil of the double-sided copper-clad laminate obtained in each example was processed into a straight line having a width of 3 mm by etching, and then dried at 105°C for 1 hour to obtain a test piece. Next, using a small table tester (manufactured by Shimadzu Corporation, trade name: EZ-Test), the strength at the time of peeling the copper foil, which is the straight line of the test piece, in the 90° direction at a speed of 50 mm/min was measured, and the strength was used as an index of the adhesion to conductors.

### (3. Method for Evaluating Heat Resistance)

The copper foils on both sides of the double-sided copper-clad laminate obtained in each example were removed by etching to prepare test pieces of 40 mm × 40 mm. Next, the test piece was treated under the conditions of 121°C and 0.11 MPa using a pressure cooker (manufactured by Hirayama Seisakusho Co., trade name: HA-300M). After immersing the treated test piece in a molten solder bath at 288°C for 20 seconds, the appearance of the test piece was visually observed, and heat resistance was evaluated according to the following criteria.
A: No swelling was observed.
C: Swelling was observed.

### (4. Evaluation of Lowest Melt Viscosity)

The resin composition obtained in each example was applied to a PET film (manufactured by Teijin Limited., trade name: G2-38) having a thickness of 38 µm, and then heated and dried at 170°C for 5 minutes to prepare a resin film in a B-stage state. This resin film was peeled from the PET film and then pulverized to obtain a resin powder in a B-stage state.

After the obtained resin powder was pulverized in a mortar, approximately 0.6 g of the resin powder was weighed and formed into a disk-shaped tablet with a diameter of 20 mm by a tablet molding machine. Subsequently, the tablet was used as a measurement sample, and the lowest melt viscosity was measured under conditions of an ascending rate of 3 °C/min, a load of 0.2N, and a measurement temperature range of 50 to 200°C, using a rheometer (manufactured by Rheometrics, trade name: ARES-2K STD-FCO-STD).

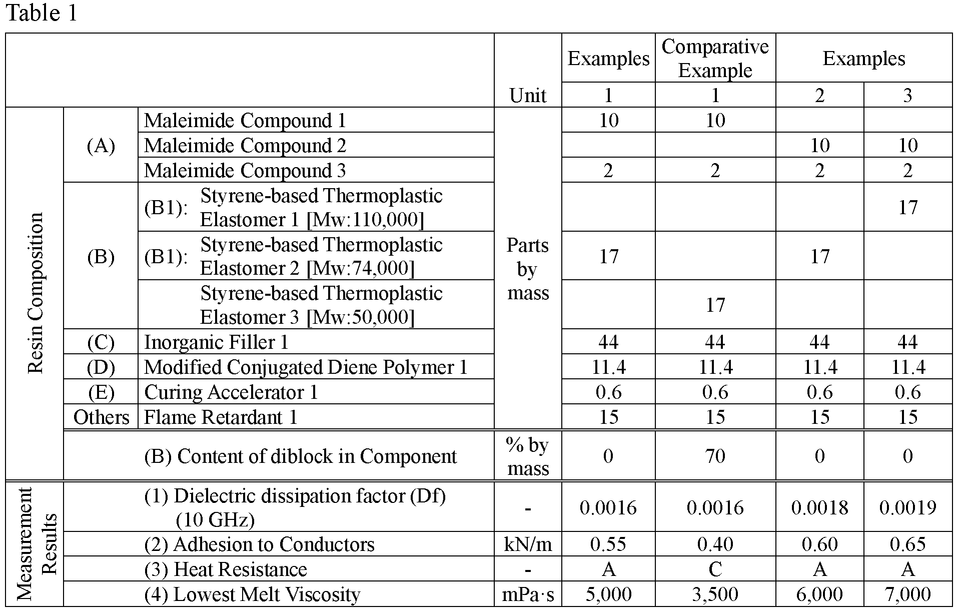

The amounts in the table are solid equivalent amounts for solutions or dispersions.

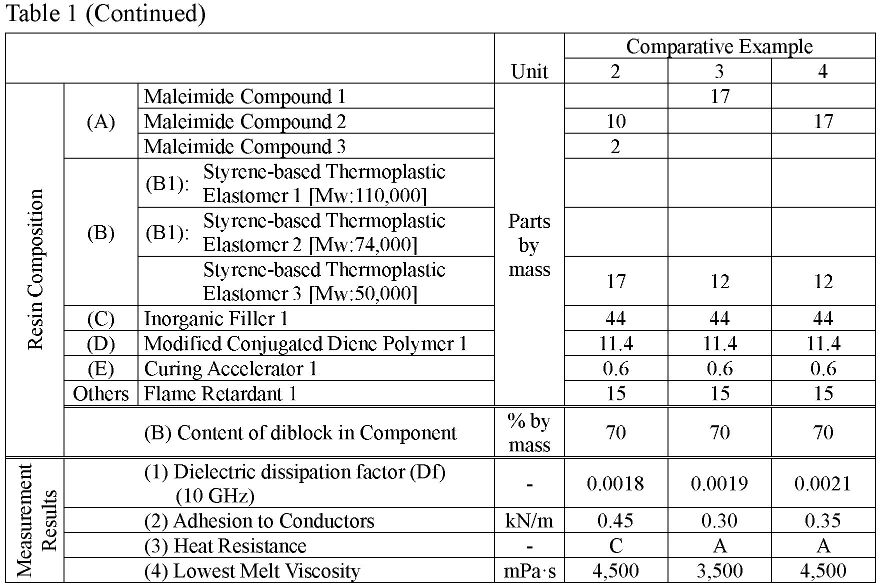

The amounts in the table are solid equivalent amounts for solutions or dispersions.

Details of each component described in Table 1 are as follows.

### [Thermosetting Resin (A)]

- Maleimide compound 1: indane ring-containing aromatic bismaleimide
- Maleimide compound 2: biphenyl aralkyl maleimide (manufactured by Nippon Kayaku Co., Ltd., trade name "MIR-3000")
- Maleimide compound 3: 3,3'-dimethyl-5,5'-diethyl-4,4'-diphenylmethane bismaleimide

### [Thermoplastic Resin (B)]

The component (B1):
- Styrene-based thermoplastic elastomer 1: styrene- (ethylene / butylene) -styrene triblock copolymer, content of diblock: 0% by mass, styrene content: 30% by mass, weight-average molecular weight (Mw) = 110,000
- Styrene-based thermoplastic elastomer 2: styrene- (ethylene / butylene) -styrene triblock copolymer, content of diblock: 0% by mass, styrene content: 30% by mass, weight-average molecular weight (Mw) = 74,000
- Styrene-based thermoplastic elastomer 3: a mixture of a styrene-(ethylene/butylene) diblock copolymer and a styrene-(ethylene / butylene)-styrene triblock copolymer, content of diblock: 70% by mass, styrene content: 30% by mass, weight-average molecular weight (Mw) = 50,000

### [Inorganic Filler (C)]

- Inorganic filler 1: fused spherical silica, average particle diameter = 0.5 µm

### [(D) one or more selected from the group consisting of a conjugated diene polymer and a modified conjugated diene polymer]

- Modified conjugated diene polymer 1: a modified conjugated diene polymer prepared in Production Example 1

### [Curing Accelerator (E)]

- Curing accelerator 1: Dicumyl peroxide

### [Others]

- Flame retardant 1: Aluminum trisdiethylphosphinate

In Table 1, it can be seen that the copper-clad laminates of Examples have good high-frequency characteristics, and when Example 1 and Comparative Example 1 and Examples 2 to 3 and Comparative Example 2 are compared with each other, the copper-clad laminates of Examples have high adhesion to conductors and are excellent in heat resistance.

On the other hand, it can be seen that in the copper-clad laminates of Comparative Examples 1 to 4 not containing the component (B 1), show a decrease in at least one of adhesion to conductors and heat resistance.

## Claims

1. A resin composition comprising:
a thermosetting resin (A); and
a thermoplastic resin (B), wherein
the thermoplastic resin (B) contains a block copolymer (B 1) including a block (b 1) that contains a structural unit derived from an aromatic hydrocarbon compound, and a block (b2) that contains a structural unit derived from a conjugated diene compound,
the component (B 1) does not contain a diblock copolymer, or when the component (B1) contains a diblock copolymer, the content of the diblock copolymer is 50% by mass or less in the component (B 1), and
the weight-average molecular weight of the component (B1) is 130,000 or less.

2. The resin composition according to Claim 1, wherein
the conjugated diene compound is one or more selected from the group consisting of butadiene and isoprene.

3. The resin composition according to Claim 1, wherein
in the (B1) component, the block (b2) further contains a structural unit derived from an aromatic hydrocarbon compound, and in the block (b2), a content ratio of the structural unit derived from the conjugated diene compound to the structural unit derived from the aromatic hydrocarbon compound [structural unit derived from conjugated diene compound/structural unit derived from aromatic hydrocarbon compound] is 99/1 to 50/50.

4. The resin composition according to Claim 1, wherein
the thermosetting resin (A) contains one or more selected from the group consisting of an epoxy resin, a maleimide compound, a modified polyphenylene ether resin, a phenolic resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

5. The resin composition according to Claim 4, wherein
the maleimide compound contains one or more selected from the group consisting of a maleimide compound having one or more N-substituted maleimide groups and a derivative of the maleimide compound.

6. The resin composition according to Claim 5, wherein
the maleimide compound contains one or more selected from the group consisting of an aromatic bismaleimide compound having two N-substituted maleimide groups bonded to an aromatic ring and an aromatic polymaleimide compound having three or more N-substituted maleimide groups bonded to an aromatic ring.

7. The resin composition according to Claim 6, wherein
the aromatic bismaleimide compound having two N-substituted maleimide groups bonded to an aromatic ring contains an indane ring-containing aromatic bismaleimide, and the aromatic polymaleimide compound having three or more N-substituted maleimide groups bonded to an aromatic ring contains a biphenyl aralkyl maleimide.

8. The resin composition according to Claim 1, further comprising:
an inorganic filler (C).

9. The resin composition according to Claim 1, further comprising:
(D) one or more selected from the group consisting of a conjugated diene polymer and a modified conjugated diene polymer.

10. A prepreg comprising:
the resin composition according to Claim 1 or a semi-cured product of the resin composition.

11. A resin film comprising:
the resin composition according to Claim 1 or a semi-cured product of the resin composition.

12. A laminate comprising:
a cured product of the resin composition according to Claim 1 or a cured product of the prepreg according to Claim 10; and
a metal foil.

13. A printed wiring board comprising:
a cured product of the resin composition according to Claim 1.

14. A semiconductor package comprising:
the printed wiring board according to Claim 13; and
a semiconductor element.
